# FASCICULE DE BREVET EUROPEEN

(11) **EP 0 421 897 B1**
(45) Date de publication et mention de la délivrance du brevet: **04.01.1995**
(21) Numéro de dépôt: 90420424.5
(22) Date de dépôt: 01.10.1990
(51) Int. Cl.: H04N 7/00

(54) **Extracteur de données numériques dans un signal vidéo**
Vorrichtung zum Extrahieren von digitalen Daten aus einem Video-Signal
Device for extracting digital data from a video signal

(30) Priorité: 03.10.1989 FR 8913171
(43) Date de publication de la demande: 10.04.1991
(73) Titulaire: SGS-THOMSON MICROELECTRONICS S.A., 94250 Gentilly (FR)
(72) Inventeur: Meyer, Jacques, F-38700 Corenc (FR)
(74) Mandataire: de Beaumont, Michel

(56) Documents cités:
- EP-A- 0 022 723
- PATENT ABSTRACTS OF JAPAN, vol. 6, no. 37 (E-97)[915], 6 mars 1982;& JP-A-56 157 124 (TOKYO SHIBAURA DENKI K.K.) 04-12-1981
- PATENT ABSTRACTS OF JAPAN, vol. 9, no. 136 (E-320), 12 juin 1985;& JP-A-60 018 079 (TOSHIBA K.K.) 30-01-1985
- PATENT ABSTRACTS OF JAPAN, vol. 10, no. 201 (E-419)[2257], 15 juillet 1986; JP-A-61 43 886 (HITACHI LTD) 03-03-1986
- PATENT ABSTRACTS OF JAPAN, vol. 9, no. 332 (E-370), 26 décembre 1985; & JP-A-60 163 528 (MATSUSHITA DENKI SANGYO K.K.) 26-08-1985

## Description

La présente invention concerne de façon générale la réception de signaux numériques transmis sur un canal de télévision.

En effet, des systèmes de plus en plus nombreux utilisent le réseau existant d'émetteurs de télévision pour transmettre des données numériques. On peut par exemple citer des systèmes de transmission de messages ou des systèmes de déclenchement d'un actionneur, par exemple d'un actionneur de mise en route automatique d'un magnétoscope au début d'une émission de télévision.

De façon générale, les signaux numériques sont émis dans l'espace libre existant pendant la période de retour trame du signal de télévision.

On suppose dans ce qui suit que le récepteur de télévision a classiquement identifié les périodes de retour trame et est donc capable d'établir, au moins de façon approximative, des fenêtres pendant lesquelles sont susceptibles d'apparaître les signaux numériques. Plus particulièrement, au cours de chaque période de retour trame, deux fenêtres sont produites, la première pendant laquelle apparaissent des signaux émis constitués d'une suite alternée de zéros et de uns et la deuxième pendant laquelle apparaissent les signaux de données recherchés.

Pour reconnaître (extraire) les données numériques, il faut, à chaque temps d'horloge des données incidentes, déterminer si le niveau est haut ou bas (1 ou 0) c'est-à-dire comparer les données incidentes à un (ou deux) seuil (s) de décision. D'autre part, il faut effectuer cette comparaison à un instant approprié au cours de la durée d'horloge, c'est-à-dire effectuer un réglage de phase de l'horloge.

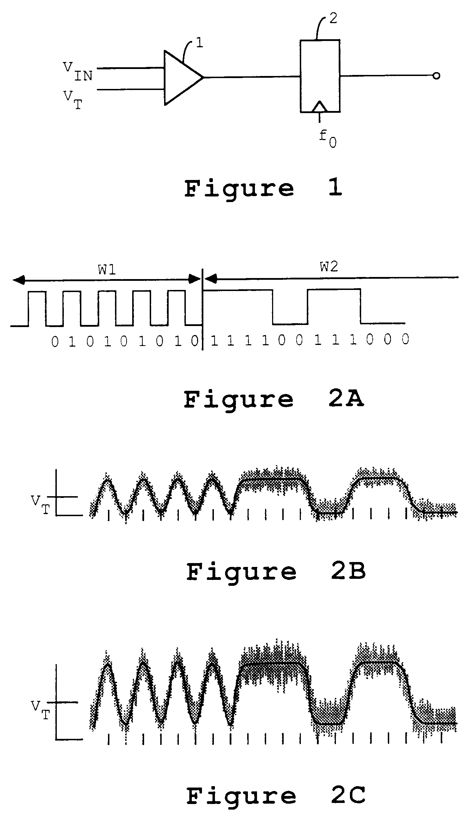

Un dispositif de reconnaissance est illustré très schématiquement en figure 1 : les signaux incidents V_{IN} sont fournis à la première entrée d'un comparateur 1 dont la deuxième entrée est reliée à une tension de seuil V_{T} ; la sortie du comparateur est reliée à une bascule 2 actionnée par une horloge f0 correspondant à la cadence des données numériques.

En fait, cette analyse est rendue délicate en raison des différentes perturbations que subit le signal vidéo. En effet, la figure 2A illustre un exemple de signal numérique comprenant, pendant une fenêtre W1, une suite alternée de zéros et de uns puis, pendant une fenêtre W2 un mot numérique, par exemple 111100111000.... Comme l'illustrent les figures 2B et 2C, le signal arrivant sur le comparateur 1 n'est pas le signal idéal de la figure 2A mais un signal à bande passante volontairement réduite à l'émission et perturbé par la transmission.

D'une part, comme le montre la comparaison des figures 2B et 2C, l'amplitude des données numériques peut varier dans un rapport important, couramment de 1 à 4 si, comme cela est classique, le gain du récepteur d'entrée du signal vidéo est asservi sur l'amplitude moyenne du signal vidéo pendant la trame. Ainsi ce gain sera important dans le cas d'une image sombre (cas de la figure 2C) et faible dans le cas d'une image claire (cas de la figure 2B).

D'autre part, la phase et l'amplitude des signaux sont perturbées par les filtrages et les imperfections de réglage en entrée du téléviseur ainsi que par les réceptions d'échos et autres parasites.

Enfin, le bruit blanc accompagnant tout signal transmis est éventuellement important.

Il en résulte notamment que le niveau de seuil V_{T} auquel est comparé le signal d'entrée V_{IN} doit être ajusté en fonction de l'amplitude de ce signal d'entrée. Il est souhaitable que ce niveau V_{T} soit ajusté à une valeur sensiblement égale à la moitié de l'amplitude crête du signal d'entrée. On s'affranchit ainsi des fluctuations liées au bruit. D'autre part, il est souhaitable que la détection se fasse sensiblement au milieu de la durée d'un 1 ou d'un 0 pour que l'on se trouve dans la zone où le bruit a la plus faible influence.

Dans l'art antérieur, pour résoudre ce problème, on a eu recours à des solutions de type analogique ou de type numérique.

Les solutions classiques de type analogique consistent à mémoriser après passage dans un filtre passe-bas le niveau de crête sur un condensateur pour fournir ensuite à partir de là le niveau de détection. On peut également prévoir de détecter et mémoriser sur un condensateur les niveaux maximum et minimum des données et d'effectuer leur demi-somme. Pour déterminer la phase, on utilise classiquement alors des boucles à verrouillage de phase dont les diverses valeurs de consigne sont mémorisées par des condensateurs. Les inconvénients de ces solutions analogiques sont bien connues : les valeurs des composants sont critiques et nécessitent des ajustements précis ; la mémorisation de ces valeurs est délicate car elle est sensible au bruit et dépend du contenu du signal ; enfin ces solutions nécessitent l'emploi de condensateurs de forte valeur et d'une inductance pour l'oscillateur de boucle à verrouillage de phase, et ces composants ne sont pas intégrables, ce qui nécessite de prévoir sur le circuit intégré des bornes de connexion vers des composants externes.

Les solutions classiques de type numérique consistent à convertir le signal incident sous forme numérique grâce à un convertisseur analogique/numérique, après quoi le signal est traité numériquement de diverses manières (corrélation, filtrage numérique, annulation d'écho, etc). Cette solution présente par rapport à la solution analogique l'avantage d'utiliser des composants intégrables mais souffre de l'inconvénient que le convertisseur analogique/numérique doit fonctionner à une fréquence élevée devant la fréquence de signal d'entrée qui est elle-même, classiquement dans le domaine de la télévision, de l'ordre de quelques MHz. En outre, il faudra généralement prévoir des multiplieurs numériques et tous ces circuits sont relativement complexes et occupent une surface de silicium importante.

Ainsi, un objet de la présente invention est de prévoir un extracteur de données numériques dans un signal de télévision qui soit particulièrement simple à réaliser et dont les composants soient intégrables.

Pour atteindre cet objet, la présente invention prévoit un extracteur de donnés numériques transmises à une première fréquence déterminée par un canal vidéo après une salve de 0 et 1 émise à la première fréquence, comprenant un comparateur pour comparer le signal d'entrée à un niveau de seuil, des moyens pour fournir une deuxième fréquence multiple de la première fréquence, et des moyens pour fournir ledit niveau de seuil, actif pendant la durée de ladite salve, dans lequel les moyens de fourniture du niveau de seuil comprennent un compteur-décompteur fonctionnant à la fréquence multiple et dont l'entrée de comptage-décomptage est reliée à la sortie du comparateur, un convertisseur numérique/analogique recevant la sortie du compteur-décompteur et fournissant ledit niveau de seuil et la sortie du comparateur est reliée à un détecteur de front agissant, pendant ladite salve, sur un diviseur par N de la fréquence multiple pour fournir à une bascule connectée à la sortie du comparateur un signal d'horloge à la première fréquence avec la relation de phase souhaitée.

Selon un mode de réalisation de la présente invention, le convertisseur numérique/analogique est du type exponentiel.

Selon un mode de réalisation de la présente invention, la sortie du comparateur est reliée à un filtre numérique du type à détection de majorité.

Un avantage du circuit selon la présente invention réside dans sa simplicité notamment du fait que la fréquence multiple susmentionnée peut être seulement 4 à 10 fois plus élevée que la cadence des données. En outre, comme cela ressortira des exemples ci-après, le compteur-décompteur et le convertisseur numérique/analogique peuvent être des dispositifs à petit nombre de bits et occuperont une faible surface de silicium tout en fournissant un niveau de seuil relativement précis.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1 et 2A-2C destinées à aider à l'exposé de l'état de la technique et à faire ressortir le problème posé ont été décrites précédemment ;
la figure 3 représente de façon schématique l'ensemble d'un extracteur de données selon la présente invention ;
la figure 4 représente des signaux en divers points du circuit de la figure 3 pour en illustrer le fonctionnement ;
la figure 5 représente un exemple de comparateur utilisable selon la présente invention ;
la figure 6 représente un exemple de convertisseur numérique/analogique utilisable selon la présente invention.

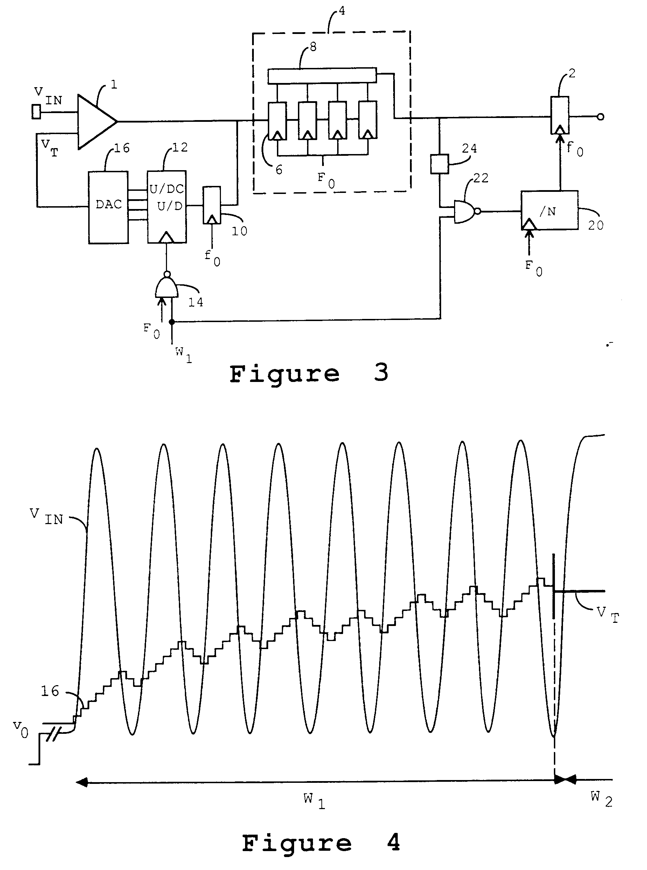

Le circuit selon la présente invention illustrée en figure 3 comprend, comme le circuit antérieur illustrée en figure 1, un comparateur 1 recevant sur une première entrée la tension V_{IN} du signal comprenant les données numériques et sur sa deuxième entrée la tension de seuil V_{T} à laquelle cette tension d'entrée doit être comparée. La sortie du comparateur 1 est également fournie à une bascule 2 actionnée à la fréquence f0 des données numériques. Entre le comparateur 1 et la bascule 2 est inséré un filtre numérique 4 comprenant par exemple une succession de bascules de type D 6 actionnées à une fréquence F0 multiple de la fréquence f0 et produite à partir de celle-ci. Un circuit logique 8 dit de détection de majorité fournit comme signal de sortie le signal correspondant à celui fourni par le plus grand nombre des bascules 6 qui sont par exemple au nombre de 5.

La tension de seuil V_{T} est fournie par une boucle comprenant une deuxième bascule 10 connectée à la sortie du comparateur 1 et actionnée à la fréquence d'horloge F0. Un compteur-décompteur 12 (U/D C) reçoit sur son entrée de comptage-décomptage (U/D) la sortie de la bascule 10 et sur son entrée d'horloge, par l'intermédiaire d'une porte NON ET 14, le signal d'horloge F0 pendant la durée de la fenêtre W1 mentionnée précédemment en relation avec la figure 2A. Ainsi ce compteur-décompteur 12 ne sera actif une pendant la durée de cette fenêtre, c'est-à-dire pendant la durée de la salve initiale de zéros et de uns alternés précédent chaque arrivée de données. La sortie du compteur-décompteur 12 est reliée à un convertisseur numérique/analogique (DAC) 16 dont la sortie analogique correspond à la tension de seuil V_{T}.

Le signal f0 d'échantillonnage de la première bascule 2 fournissant en sortie les données recherchées est fourni par un diviseur par N, 20, (F0 = Nf0) ce diviseur recevant la fréquence d'horloge F0 et étant remis à 0 par la sortie d'une porte NON ET 22 dont la première entrée reçoit le signal de fenêtre W1 et dont la deuxième entrée reçoit la sortie du filtre numérique 4 par l'intermédiaire d'un détecteur de front 24.

Le fonctionnement de ce circuit, pendant la durée de la fenêtre W1 va être expliqué en relation avec la figure 4. Cette figure représente d'une part l'allure du signal d'entrée V_{IN} pendant la durée de la fenêtre W1 et d'autre part la sortie du convertisseur 16 (désignée par la référence 16) permettant d'élaborer le signal V_{T} qui sera utilisé pendant la durée de la fenêtre W2. On suppose que la valeur initiale de la sortie du convertisseur numérique/analogique 16 est égale à v0. Cette valeur est représentée dans la figure comme étant une valeur faible. La comparaison de cette valeur v0 et de la valeur V_{IN} entraîne pendant la première alternance positive du signal V_{IN} la croissance du signal 16. En effet, le comparateur 1 détermine que V_{IN} est plus grand que v0 et la bascule 10 active le compteur-décompteur 12 dans le sens du comptage. Le convertisseur numérique/analogique 16 fournit donc, au rythme de la fréquence F0 une tension croissant par palier. Cette tension décroît ensuite pendant les alternances négatives et ainsi de suite. Tant que la sortie du convertisseur numérique/analogique 16 se trouve en dessous de la valeur sensiblement médiane de la sinusoïde correspondant au signal V_{IN}, les phases de croissance seront plus longues que les phases de décroissance ; ensuite, cette sortie variera autour d'une valeur moyenne, les phases de croissance ayant sensiblement la même durée que les phases de décroissance On trouvera donc à la fin de la fenêtre W1 une valeur de la sortie du convertisseur numérique/analogique 16 qui sera sensiblement égale à la valeur moyens de la sinusoïde.

On a donc résolu, grâce à la présente invention et de façon très simple, le problème de l'élaboration d'une tension de seuil V_{T} sensiblement égale à la valeur moyenne du signal d'entrée pendant la salve de réglage initiale.

Il convient également d'assurer un réglage de phase du signal f0 pour, lors de l'extraction des données, effectuer cette extraction au voisinage d'un minimum ou d'un maximum des signaux reçus, c'est-à-dire sensiblement au milieu de leur durée. Pour cela, la présente invention utilise le détecteur de front 24 relié par la porte NON ET 22 à l'entrée de remise à 0 du diviseur par N 20. Ainsi, ce diviseur par N fournit la fréquence f0 à partir de la fréquence F0, avec un recalage en fréquence à chaque passage à 0 ou 1 de la sortie du comparateur 1 telle que filtrée par le filtre 4. Il suffira de prendre une sortie du compteur décalée d'un nombre de pas suffisant de la fréquence F0 par rapport aux remises à 0 pour obtenir le signal f0 de phase convenable en tenant compte des caractéristiques du filtre numérique 4.

Tous les circuits utilisés dans la présente invention en relation avec la figure 3 sont classiques pour l'homme de l'art.

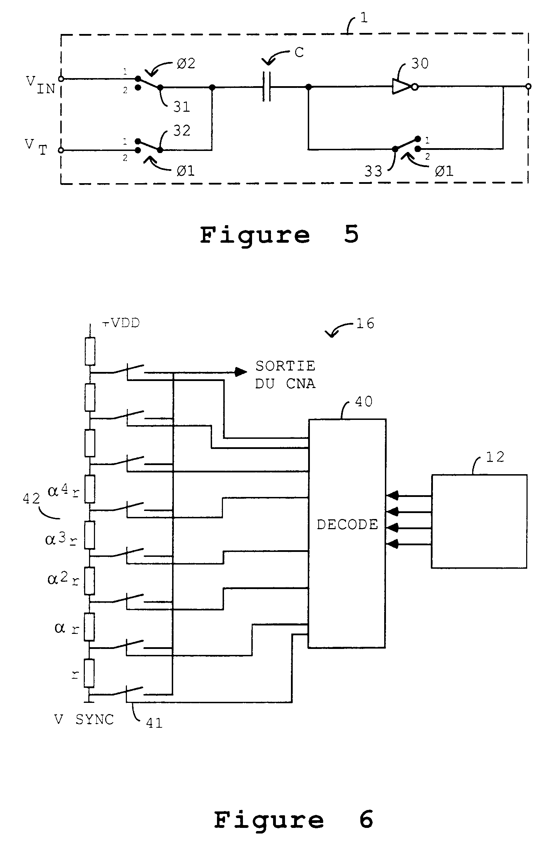

En ce qui concerne le comparateur 1, on pourra utiliser un comparateur à auto-zéro du type de celui illustré en figure 5 comprenant un condensateur C et un amplificateur-inverseur 30 ainsi qu'un premier interrupteur 31 connecté entre l'entrée V_{IN} et une première borne du condensateur, un deuxième interrupteur 32 connecté entre l'entrée V_{T} et la première borne du condensateur et un troisième interrupteur 33 connecté en parallèle sur l'inverseur 30. Les interrupteurs 32 et 33 sont fermés pendant une première phase φ1 de la période de l'horloge F0 et l'interrupteur 31 est fermé pendant une deuxième phase φ2 de cette période. Comme cela est connu, ce montage permet d'éviter les défauts de décalage de tension (offset) d'un comparateur.

Le convertisseur numérique/analogique 16 peut être du type de celui illustré en figure 6 comprenant un circuit de décodage 40 recevant les sorties du compteur 12 et commandant des interrupteurs 41 d'un pont diviseur 42. De préférence, le pont diviseur est du type exponentiel, c'est-à-dire que les résistances ont des valeurs successives r, αr, α²r, α³r ... Ainsi, les créneaux de sortie du convertisseur numérique/analogique s'adaptent rapidement à la valeur de la tension V_{IN} même si celle-ci varie dans une plage importante comme cela a été exposé précédemment.

Dans une réalisation pratique, la salve d'horloge dure seize périodes, c'est-à-dire huit cycles de zéros et de uns alternés. Il faut donc que le système de détection soit assez rapide pour trouver le niveau de signal en huit cycles. La fréquence du signal d'entrée est d'environ 7 MHz. Si l'on choisit N = 6, on aura F0 = 42 MHz et le convertisseur numérique/analogique pourra comprendre seize niveaux en loi exponentielle, le compteur-décompteur ayant une capacité de six bits, seuls les quatre bits de poids fort étant reliés au convertisseur numérique/analogique.

De préférence, contrairement à ce qui a été représenté en figure 4 dans laquelle la valeur v0 initiale de sortie du compteur est faible, le compteur sera initialisé à sa valeur moitié. De cette façon, celui-ci pourra rapidement atteindre les valeurs extrêmes en 32 périodes à la fréquence F0 soit pendant le premier tiers de la période d'horloge.

La loi de variation exponentielle du convertisseur sera de préférence calculée de sorte que le nombre de niveaux entre les valeurs extrêmes du signal d'entrée soit indépendant de l'amplitude de ce signal. Ainsi le comportement du système est toujours le même, seul le niveau moyen du compteur-décompteur variant en fonction de l'amplitude moyenne du signal vidéo pendant la salve d'horloge.

## Revendications

1. Extracteur de données numériques transmises à une première fréquence déterminée (f0) par un canal vidéo après une salve de 0 et 1 émise à la première fréquence (f0), comprenant un comparateur (1) pour comparer le signal d'entrée à un niveau de seuil, des moyens pour fournir une deuxième fréquence (F0) multiple de la première fréquence (f0), et des moyens de fourniture dudit niveau de seuil actifs pendant la durée de ladite salve, caractérisé en ce que les moyens de fourniture du niveau de seuil comprennent :
un compteur-décompteur (12) fonctionnant à la fréquence multiple (F0) et dont l'entrée de comptage-décomptage est reliée à la sortie du comparateur (1), et
un convertisseur numérique/analogique (16) recevant la sortie du compteur-décompteur et fournissant ledit niveau de seuil (V_{T}) ; et
en ce que la sortie du comparateur est reliée à un détecteur de front (24) agissant, pendant ladite salve, sur un diviseur par N (20) de la fréquence multiple (F0) pour fournir à une bascule (2) connectée à la sortie du comparateur un signal d'horloge à la première fréquence (f0) avec la relation de phase souhaitée.

2. Extracteur de données numériques selon la revendication 1, caractérisé en ce que le convertisseur numérique/analogique (16) est du type exponentiel.

3. Extracteur de données selon la revendication 1, caractérisé en ce que la sortie du comparateur est reliée à un filtre numérique du type à détection de majorité (6, 8).

## Patentansprüche

1. Vorrichtung zum Extrahieren von digitalen Daten, welche bei einer ersten vorgegebenen Frequenz (f0) über einen Videokanal nach einem bei der ersten Frequenz (f0) gesendeten Burst von 0 und 1 übertragen wurden, mit einem Vergleicher (1) zum Vergleichen des Eingangssignales mit einem Schwellwert, einer Vorrichtung zum Liefern einer zweiten Frequenz (F0), welche ein Vielfaches der ersten Frequenz (f0) ist, und einer Vorrichtung zum Liefern des Schwellwertes, die während der Dauer des Bursts aktiv ist, dadurch **gekennzeichnet**, daß die Vorrichtung zum Liefern des Schwellwertes folgende Merkmale aufweist:
einen Aufwärts-Abwärtszähler (12), welcher bei der vielfachen Frequenz (F0) arbeitet und dessen Aufwärts-Abwärts-Zähleingang mit dem Ausgang des Vergleichers (1) verbunden ist, und
einen Digital-Analog-Umsetzer (16), der das Ausgangssignal des Aufwärts-Abwärtszählers empfängt und den Schwellwert (V_{T}) liefert, und
daß der Ausgang des Vergleichers mit einem Flankendetektor (24) verbunden ist, welcher während des Bursts auf einen Teiler-durch-N (20) für die mehrfache Frequenz (F0) einwirkt, um einer mit dem Ausgang des Vergleichers verbundenen Kippschaltung (2) ein Taktsignal der ersten Frequenz (f0) mit der gewünschten Phasenbeziehung zu liefern.

2. Vorrichtung zum Extrahieren von digitalen Daten nach Anspruch 1, dadurch **gekennzeichnet**, daß der Digital-Analog-Umsetzer (16) ein Exponential-Umsetzer ist.

3. Vorrichtung zum Extrahieren von Daten nach Anspruch 1, dadurch **gekennzeichnet**, daß der Ausgang des Vergleichers mit einem digitalen Mehrheitserfassungs-Filter (6, 8) verbunden ist.

## Claims

1. An extractor for digital data transmitted at a first determined frequency (f0) through a video channel after a burst of 0s and 1s emitted at said first frequency (f0) onto the first input (V_{IN}), a comparator (1) for comparing said input signal with a threshold level, means for supplying a second frequency (F0) multiple of the first frequency (f0), and means for supplying said threshold level, operating during said burst duration, characterized in that the means for supplying the threshold level comprise:
an up/down counter (12) operating at said multiple frequency (F0), the up/down counting input of which is connected to the output of said comparator (1), and
a digital/analog converter (16) receiving the output of the up/down counter and supplying said threshold level (V_{T}); and
in that the comparator output is connected to an edge detector (24) acting, during said burst, on a divider by N (20) of the multiple frequency (F0) for supplying to a flip-flop (2), connected to the comparator output, a clock signal at the first frequency (f0) with the desired phase relationship.

2. A digital data extractor according to claim 1, characterized in that the digital/analog converter (16) is of the exponential type.

3. A digital data extractor according to claim 1, characterized in that the comparator output is connected to a digital filter of the majority detection type (6, 8).
